# EUROPEAN PATENT APPLICATION

(11) **EP 4 492 446 A1**
(43) Date of publication of application: **15.01.2025**
(21) Application number: 23184798.9
(22) Date of filing: 11.07.2023
(51) Int. Cl.: H01L 23/00, H01L 21/683

(54) **METHOD AND SYSTEM OF PERFORMING COLLECTIVE DIE-TO-WAFER BONDING**

(71) Applicant: IHP GmbH - Innovations for High Performance Microelectronics / Leibniz-Institut für innovative Mikroelektronik, 15236 Frankfurt (Oder) (DE)
(72) Inventor: Schulze, Sebastian, 15236 Frankfurt (Oder) (DE); Wietstruck, Matthias, 15236 Frankfurt (Oder) (DE); Voß, Thomas, 15236 Frankfurt (Oder) (DE); Krüger, Patrick, 15236 Frankfurt (Oder) (DE)
(74) Representative: Eisenführ Speiser

(57) **Abstract**

The present invention relates to a method of performing collective die-to-wafer bonding. The method comprises the steps of:
- providing a carrier wafer having a back side and a bonding side opposite the back side and comprising on the bonding side one or more pockets that each are configured for accommodating a die, respectively,
- providing a target substrate comprising an integrated circuit, hereinafter IC, and one or more target bonding pads for connecting the one or more dies to the IC,
- placing one or more dies in the one or more pockets, respectively, and
- bonding the one or more dies placed in the one or more pockets to the tar-get substrate by bringing the one or more dies into contact with the one or more target bonding pads.

## Description

### TECHNICAL FIELD

The present invention relates to a method of performing collective die-to-wafer bonding and to a system for collective die-to-wafer bonding. Furthermore, the present invention relates to a carrier wafer comprising one or more pockets configured for accommodating one or more dies, respectively. Moreover, the present invention relates to a target substrate comprising an integrated circuit with dies that are bonded to target bonding pads via die bonding pads. In particular, the present invention concerns collective die-to-wafer bonding based on surface activated metal-metal thermocompression bonding. The present invention may particularly be useful for the integration of individual chips, herein also referred to as dies, with different sizes from various production sites and technologies on one substrate.

### BACKGROUND OF THE INVENTION

3D heterogeneous integration refers to the assembly and packaging of multiple separately manufactured components onto a single chip and provides the possibility to combine dissimilar semiconductor technologies and add new components to obtain a higher performance and increase the functionality of electronic and optoelectronic devices. For achieving 3D integration, different bonding technologies can be employed such as die-to-die bonding, die-to-wafer bonding and wafer-to-wafer bonding. For example, die-to-wafer bonding allows for bonding multiple dies to a wafer in a single process.

A further approach for enabling 3D heterogeneous integration is collective die-to-wafer bonding. For example, J. Burggraf, et al. report in "Collective Die Bonding: An Enabling Toolkit for Heterogeneous Integration" 2020 ECS Trans., 98, p.173 results using a method and process flow enabling local die bonding compatible with the high alignment accuracy and cleaning requirements to support a high yield. J. Burggraf, *et al.* used a customized temporary carrier with alignment features to place known good dies on a carrier and enabled die processing prior to a final bonding process. In order to place the die on the collective carrier and lock the position during a cleaning, die preparation and transfer process, J. Burggraf, *et al.* used a carrier wafer that was coated with a commercially available temporary bonding adhesive. To separate the collective die carrier and transferred dies, laser debonding was employed.

Yet, it is still desirable to provide a method of performing collective die-to-wafer bonding that is comparatively less complex and more time efficient while, at the same time, allowing to bond dies with good alignment accuracy to a target substrate.

### SUMMARY OF THE INVENTION

The present invention is based on the objective of providing an improved method of performing collective die-to-wafer bonding. Furthermore, the present invention is based on the objective of providing an improved system for performing collective die-to-wafer bonding. Moreover, the present invention is based in the objective of providing an improved carrier wafer comprising pockets for accommodating dies. The present invention is also based in the objective of providing an improved target wafer comprising an integrated circuit and one or more dies bonded to the integrated circuit.

According to the present invention, a method of performing collective die-to-wafer bonding is proposed. The method comprises the steps of:
- providing a carrier wafer having a back side and a bonding side opposite the back side and comprising on the bonding side one or more pockets that each are configured for accommodating a die, respectively,
- providing a target substrate comprising an integrated circuit, hereinafter target IC, and one or more target bonding pads for connecting the one or more dies to the target IC,
- placing one or more dies in the one or more pockets, respectively, and
- bonding the one or more dies placed in the one or more pockets to the target substrate by bringing the one or more dies into contact with the one or more target bonding pads.

The present invention includes the recognition that wafer-to-wafer bonding has its advantages in terms of an accurate alignment, high throughput and thus lower cost. In addition, the known wafer-to-wafer bonding technology enables convenient activation and cleaning of the surface before bonding. However, wafer-to-wafer bonding reaches its limits when it comes to integrating individual chips with different sizes from various production sites and technologies on one substrate. Yet, collective die-to-wafer bonding may combine the advantages of the established wafer-to-wafer bonding and the variability of die-to-wafer bonding. This can be accomplished with collective die-to-wafer bonding in that individual dies (herein sometimes also referred to as chips) are first placed on a carrier wafer and are then bonded to a target substrate using a known wafer-to-wafer bonding process.

This is particularly possible with the method of performing collective die-to-wafer bonding according to the present invention since the carrier wafer comprises on the bonding side one or more pockets that each are configured for accommodating one or more dies, respectively. Due to the pockets, it is not necessary to use an adhesive for fixing the dies to the carrier wafer. At the same time, since the dies are placed into respective pockets, the dies can be accurately and reliably bonded to a target substrate. Thereby, the absence of adhesives allows the subsequent processing under ultra-high vacuum, which is generally needed, e.g., for low-temperature metal-metal thermocompression bonding such as aluminium-to-aluminium bonding. Furthermore, the absence of adhesives makes a complex debonding process to separate the bonded dies from the carrier wafer obsolete. A further advantage of not using adhesives is that the carrier wafer can be used several time, i.e. in a reusable manner. Thus, due to not using adhesives, processing time can be reduced. In particular, the steps needed for bonding the dies to the target substrate and subsequent debonding of the carrier wafer can be reduced. Also, the amount of material needed during the method of performing collective die-to-wafer bonding can be reduced, e.g., since no adhesive is employed. Moreover, the bonding process may generally become less complex.

Accordingly, the proposed method of performing collective die-to-wafer bonding provides a reliable multi-bonding process that is compliant to known optical alignment technology and cleaning requirements. The proposed method of performing collective die-to-wafer bonding can be conducted at combatively low cost, i.e., in a cost-effective manner. In particular, the posed method of performing collective die-to-wafer bonding can provide transfer of dies with high yield. Furthermore, the proposed method of performing collective die-to-wafer bonding makes integrating individual chips with different sizes from various production sites and technologies on one substrate possible.

In the method of performing collective die-to-wafer bonding, preferably, the dies are placed face upwards in the pockets. The dies preferably comprise one or more integrated circuits. The dies can be passive or active dies. Preferably, on face upwards side of the dies, the dies comprise one or more die bonding pads that are configured to be bonded to the target bonding pads arranged on the target substrate.

Preferably, the positons at which the dies are bonded to the target IC of the target substrate are determined by the topology of the target IC. Accordingly, the pockets preferably, are arranged at those positions that enable bonding to the correct positions at the target IC. For example, there can be a predetermined pattern of pockets, and correspondingly of dies, on the carrier wafer and a mirrored pattern of target bonding pads on the target substrate for bonding the dies to the target IC. The predetermined pattern of pockets may for example be realised using a lithographic techniques. Furthermore, the carrier wafer can be structured in a way that the pattern of pockets enables a simultaneous transfer of different dies with the same or different dimensions to several different target ICs present on the target substrate.

Preferably, the one or more pockets are each configured to accommodate only one die, respectively, i.e., one die per pocket. However, it is also possible that one or several or all of the pockets have a shape so that two dies or more can be placed in a single pocket. In this case, the pocket preferably is configured to fix the two or more dies in the target position to ensure an accurate transfer to the target IC.

Preferably, the carrier wafer is made of a crystalline semiconductor material, a poly-crystalline semiconductor material or of an amorphous material. The crystalline or poly-crystalline semiconductor material can be Si, SiC, or III-V semiconductor material such as GaAs, InP. The amorphous material can be, e.g., glass.

Preferably, in the method, providing the carrier wafer comprises etching of the one or more pockets. For example, the pockets can be etched into a crystalline semiconductor substrate, poly-crystalline semiconductor substrate or amorphous substrate to form the carrier wafer.

Additionally or alternatively, in the method, providing the carrier wafer comprises etching the one or more pockets into a first wafer and bonding the first wafer to a second wafer to obtain the carrier wafer. Preferably, the first wafer comprising the one or more pockets forms the bonding side of the carrier wafer. Using a first wafer having pockets and bonding the first wafer to the second wafer to form the carrier wafer has the advantage that it can be ensured that the pockets all have the same depth. Preferably, the pockets of the carrier wafer, e.g., formed by etching the pockets into the carrier wafer or by bonding the first wafer with pockets and the second wafer, have a depth of 200 µm to 400 µm.

A wafer carrier comprising a first wafer with pockets bonded to the second wafer can be fabricated as follows. The etched first wafer can be bonded face to face to the blanked second wafer, e.g., a blanked Si wafer. This process can be performed, e.g., by Si-Si direct bonding using a high vacuum bonding system but also other bonding methods, e.g., SiOz-SiOz bonding or metal-metal bonding is possible.

Fabricating the wafer carrier comprising a first wafer with pockets bonded to the second wafer can include that both wafers, i.e., the first and the second wafer, are activated with an argon plasma to remove any surface oxides. To prevent re-oxidation, the first and second wafers can be handled under high vacuum during the entire bonding process, which, preferably, is carried out at room temperature. Typical process conditions may be a bonding time of up to 1 min and a bonding force of up to 60 kN.

Preferably, in the method, the bonded first wafer is ground until the one or more etched pockets are exposed to form the bonding side of the carrier wafer. Grinding can be achieved with a mechanical grinding process, but also with chemical-mechanical polishing or wet/dry etching techniques. This approach may reliably ensure that the carrier wafer provides minimum total thickness variations, i.e., comparable depths of all pockets. Moreover, possible variations that may occur during etching can be avoided. This is advantageous to ensure that the bonding interface of all individual chips/dies will have the same height level to provide a high yield bonding process.

In the method, it is further preferred that a thickness of the one or more dies is greater than a depth of the one or more pockets that accommodate the one or more dies, respectively. In particular, the thickness of the dies, preferably, is greater than the depth of the pockets to ensure that they stick out of the surface. For example, a suitable chip/die thickness is between 400 µm and 750 µm.

Preferably, in the method, a given pocket of the one or more pockets, seen in a top view, defines an opening that is no more than 1 µm larger in each lateral direction than a surface area of a cross-section of a die of the one or more dies that is to be placed in that pocket. Accordingly, it is preferred that the pocket size is slightly larger than the die size. Correspondingly, a size of a respective die preferably is marginally smaller than the pocket size, which may finally influence the alignment accuracy of the bonded dies. For example, with a die placement accuracy of 0.5 µm, the pocket size should be approximately up to 1 µm larger than the die size in x and y directions. For example, a typical size of a die may be in the range of 0.5 µm x 0.5 µm to 50 mm x 50 mm.

Optionally, in the method, placing the one or more dies in the one or more pockets comprises aligning the one or more dies relative to the one or more pockets. The alignment is preferably carried out before placing the one or more dies in the one or more pockets, respectively. Preferably, the one or more dies are aligned relative to the one or more pockets such that each die can be placed into a respective pocket in a centred manner, i.e., with approximately constant distances or spaces to the pocket side walls at all pocket sides. The alignment of the one or more dies may be performed with reference to an alignment feature inherent to the one or more corresponding pockets. For example, the alignment feature may be one or more side walls of the pocket. Thereby, during the placement of the dies into the pockets, the individual dies can be directly aligned to the pockets. Additionally or alternatively to an alignment feature, the alignment of the one or more dies may be performed with reference to one or more alignment marks present on the carrier wafer. Preferably, the one or more alignment marks have a known spatial relationship relative to the one or more pockets, respectively. An alignment mark can be located, e.g., at the bottom of the pocket or the top surface of the carrier wafer. In that way, for example, an alignment accuracy below ±0.5 µm may be achieved.

In the method, it is possible that a pocket of the one or more pockets has at least one increased edge removal configured as a recess at a pocket's edge that is formed by two adjacent side walls of the pocket. For example, the one or more pockets can have a rectangular or any other shape dependent on the process. An increased edge remove may be advantageous to avoid chipping of the ICs of the dies during die placement as the edges of dies may have the highest risk for cracking.

Preferably, the one or more dies each comprise one or more die bonding pads that are configured for bonding the one or more dies to the one or more target bonding pads of the target substrate by bringing the one or more dies into contact with the one or more target bonding pads. Preferably, the collective die-to-wafer bonding is achieved by surface-activated metal-metal thermocompression bonding, e.g. Al-Al bonding or Cu-Cu bonding. In the method, it is thus preferred that one or more dies are placed in the one or more pockets such that one or more die bonding pads provided on each of the one or more dies, respectively, faces away from the wafer carrier. Preferably, the one or more target bonding pads and the one or more die bonding pads are made of or comprise an electrical conductive material. Preferably, after bonding the one or more target bonding pads and the one or more die bonding pads, an electrically conductive connection is established.

Preferably, the target bonding pads on the target substrate and the die bonding pads on the carrier wafer are arranged in a mirrored pattern. The number of the one or more target bonding pads and/or the one or more die bonding pads may depend on the application, respective pad sizes and/or chip design. In particular, the number of the one or more target bonding pads and/or the one or more die bonding pads can vary from a few to hundreds, e.g., 100 or more, 200 or more, 300 or more or 400 or more. The individual corresponding one or more target bonding pads and/or one or more die bonding pads can have the same size or even different sizes. For example, for corresponding target bonding pads and/or die bonding pads, it is possible to have larger or smaller sizes in comparison to other target bonding pads and/or die bonding pads, respectively. Yet, it is preferred that the corresponding target bonding pads and die bonding pads will form an electrical connection after bonding, in particular, also when considering the misalignment together with additional process variations.

Preferably, the target substrate on which the dies are to be bonded contains one or more IC's and target bonding pads, e.g., made of Al, arranged in a mirrored pattern compared to the die bonding pads of the dies to be bonded to the target IC or IC's.

A typical size of the target bonding pads and/or the die bonding pads may be between 5 µm × 5 µm and 100 µm × 100 µm. The target bonding pads and/or the die bonding pads may be made of aluminium or copper or copper and aluminium or can be made of other metals or metal compounds. In case the target bonding pads and/or the die bonding pads are made of aluminium, an AI-AI thermocompression bonding process may be employed. Accordingly, in case the target bonding pads and/or the die bonding pads are made of copper, a Cu-Cu thermocompression bonding process may be employed.

Preferably, the method comprises - prior to the bonding - activating the target bonding pads and/or the die bonding pads using a dry etch process. For example, the method of performing collective die-to-wafer bonding can be carried out in a high vacuum handling cluster with several modules. The carrier wafer with the inserted chips/dies and the target substrate may be handled to an activation module. Here, a dry etch process may be used to remove the oxide and potential contaminations on the metal bonding pads.

In the method, it is particularly preferred that optically aligning of the one or more dies to the one or more pockets, respectively, is carried out. An optical alignment to the carrier wafer is preferred to compensate a potential misalignment of a limited number of individual dies. For example, optical alignment can be achieved by employing alignment marks.

Using optical alignment, it is also possible to align the carrier wafer with pockets accommodating the dies to the target substrate. For example, alignment marks on both the carrier wafer and target substrate can be optically aligned to each other. This can be done using face-to-face alignment or infrared alignment.

Preferably, the method comprises separating the one or more bonded dies from the carrier wafer by moving the carrier wafer away from the target substrate. It is thus possible by simply moving the carrier wafer away from the target substrate to achieve the debonding. No further steps are required and no adhesive as employed in known methods has to be removed or modified for the debonding.

The present invention also relates to a carrier wafer comprising a first wafer with one or more exposed pockets that are each configured for accommodating a respective die. The first wafer forms a bonding side of the carrier wafer. The carrier wafer further comprises a second wafer bonded to the first wafer. The second wafer forms a backside of the carrier wafer. The carrier wafer according to the invention can be fabricated using the method of performing collective die-to-wafer bonding as described herein.

The present invention also relates to a target substrate comprising a target integrated circuit, with target bonding pads and one or more dies, each die comprising a die bonding pad. The dies are connected to the target bonding pads via the die bonding pads, respectively. The target substrate according to the invention having dies bonded thereto can be fabricated using the method of performing collective die-to-wafer bonding as described herein. Fabricating the target substrate with dies bonded thereto using the method of performing collective die-to-wafer bonding as described herein has the advantage that an interconnection density can be increased since the pads, e.g., AI layers, do not or only slightly deform during the bonding. This is possible since in comparison to other methods, high temperatures and pressures are not required in the method of performing collective die-to-wafer bonding as described herein. In known methods, yet, since performing bonding under high vacuum conditions is not possible, Al-Al bonding could only be achieved with great difficulty at very high temperatures and pressures. Using the method of performing collective die-to-wafer bonding as described herein thus significantly improves the reliability of the bonding, and in particular, of Al-Al bonding. This is particularly possible since the bonding can be performed under high vacuum conditions

Furthermore, the present invention also relates to a system for collective die-to-wafer bonding. The system can be used for carrying out the method of performing collective die-to-wafer bonding as described herein. Accordingly, the system for collective die-to-wafer bonding can be used for fabricating the carrier wafer and/or the target substrate according to the invention.

The system comprises a carrier wafer providing unit, a target substrate providing unit, a die placement unit and a die bonding unit. The carrier wafer providing unit is configured for providing a wafer carrier having a back side and an opposite bonding side and comprising on the bonding side one or more pockets that each are configured for accommodating a die. The target substrate providing unit is configured for providing a target substrate comprising a target IC and one or more target bonding pads for connecting the one or more dies to the target IC. The die placement unit is configured for placing one or more dies in the one or more pockets, respectively. Moreover, the die bonding unit is configured for bonding the one or more dies placed in the one or more pockets to the target substrate by bringing the one or more dies in contact with the one or more target bonding pads. In particular, for handing and transferring the dies, the carrier wafer and the target substrate, the system may comprise pick and place equipment, such as robot arms. For example, the system can be a high vacuum handling cluster with pick and place equipment.

In the system, the die bonding unit may comprise an activation module that is configured for performing a dry etch process for activating the one or more target bonding pads. With the dry etch process, the oxide and potential contaminations on the metal bonding pads can be removed.

Additionally or alternatively, the die bonding unit may comprise a vacuum align module configured for optically aligning the carrier wafer and the target substrate. For example, the system may be configured such that, the carrier wafer and/or the target substrate can be handled to the vacuum align module were the flipped target substrate is optically aligned to the carrier wafer without breaking vacuum to avoid a re-oxidation.

Optionally, the die bonding unit comprises bonding chamber that is configured to provide one or more predetermined bonding conditions within the bonding chamber. For example, the one or more predetermined bonding conditions can be a bonding pressure of up to 60 MPa, a temperature of up to 300 °C and a bonding time of up to 1 hour, e.g., for an aluminium-to-aluminium bonding. After the bonding, the carrier wafer and the target substrate can be cooled, e.g., to room temperature.

Preferably, the die bonding unit comprises bonding robot arm configured for bringing the one or more dies in contact with the one or more target bonding pads. For separating the bonded dies from the carrier wafer, the target substrate and the carrier wafer can be moved out of the bonding chamber using a dedicated debonding tool. Since no adhesive is involved for fixing the dies to the carrier wafer, the target wafer with the bonded chips/dies can easily be separated from the carrier wafer. During the separation, it is preferred to enable a highly-accurate parallel separation to not to risk any mechanical contact between the pocket and the transferred die edges.

A debonding tool, preferably, is or comprises a semi-automatic debonding system, e.g., EVG805. The carrier wafer and the target substrate may be fixed to a lower and an upper chuck, respectively. By moving the two chucks in parallel in opposite directions, the carrier wafer and the target substrate may be mechanically separated.

Preferably, the carrier wafer providing unit comprises a carrier wafer robot arm configured for handling the carrier wafer. Preferably, the carrier wafer providing unit comprises a pocket etching unit configured for etching of the one or more pockets. For etching the pockets, lithographic techniques may be employed. Preferably, the target substrate providing unit comprises a target substrate robot arm configured for handling the target substrate.

To produce the carrier wafer that provides the pockets, a variety of photolithography, etching and cleaning tools may be used. Each tool preferably has its own handling system that is tailored to the process and the carrier wafer. Especially for the bonding step, the handling robot for the carrier wafer and the target substrate preferably is high vacuum compatible.

It shall be understood that the aspects described above, and specifically the method of claim 1, and the system of claim 13, have similar and/or identical preferred embodiments, in particular as defined in the dependent claims.

It shall be further understood that a preferred embodiment of the present invention can also be any combination of the dependent claims or above embodiments with the respective independent claim.

These and other aspects of the invention will be apparent from and elucidated with reference to the embodiments described hereinafter with reference to the drawings.

### BRIEF DESCRIPTION OF THE DRAWINGS

- Fig. 1:: shows a flow diagram representing a method of collective die-to-wafer bonding;
- Fig. 2:: schematically and exemplary shows the concepts of a) die-to-die (D2D) bonding, of b) die-to-wafer (D2W) bonding, c) wafer-to-wafer (W2W) bonding and d), the concept of collective die-to-wafer (CD2W) bonding;
- Fig. 3:: shows a flow diagram representing a method of fabricating a carrier wafer;
- Fig. 4:: schematically and exemplary shows a pocket in a top view; and
- Fig. 5:: schematically and exemplary shows a system for collective die-to-wafer bonding.

### DETAILS DESCRIPTION OF EMBODIMENTS

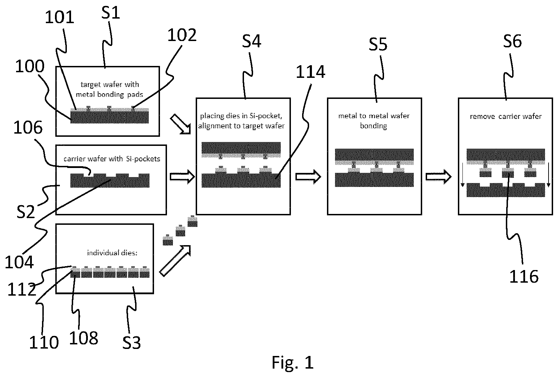

Figure 1 shows a flow diagram representing a method of collective die-to-wafer bonding. In the respective boxes of the flow diagram, the intermediate products present in the method of collective die-to-wafer bonding are schematically and exemplary shown. The method of collective die-to-wafer bonding provides a collective die-to-wafer bonding concept based on surface-activated metal-metal thermocompression bonding, which involves the production of a reusable carrier wafer, e.g., made of Si, on which one or more dies are placed without additional adhesives.

In the method of collective die-to-wafer bonding, a target substrate 100 with target bonding pads 102 made of a metal, e.g., aluminium, are provided (step S1). The target substrate 100 also comprise a target IC 101. Moreover, a carrier wafer 104 is provided, the carrier wafer 104 comprising a plurality of pockets 106, e.g., Si-pockets, (step S2). Furthermore, a plurality of dies 108 are provided (step S3). The dies 108 each comprise an IC 110 and one or more die bonding pads 112 that are also made from a metal, e.g. made from aluminium or copper. The die bonding pads 112 may have a size from 5 µm x 5 µm to 100 µm x 100 µm. in the method, passive or active dies can be used.

The individual dies 108 to be bonded are placed face-up into the pockets 106 of the carrier wafer 104 (step S4). A thickness of the dies, e.g., between 400 µm and 730 µm, is preferably greater than a depth of the etched pockets 106 such that they stick out of the surface on the carrier wafer's bonding side 114. A size of the dies 108 is preferably marginally smaller than a size of the pockets 106, which may finally influence the alignment accuracy of the bonded dies. During the placement of the dies 108 into the pockets 106, the individual dies 108 can be directly aligned to the pocket 106 or additional alignment marks, e.g., at the bottom of the pocket 106 or the top surface on the carrier wafer's bonding side 114 can also be applied. Thereby, with available die placement technologies, an alignment accuracy below ±0.5 µm may be achieved.

In a metal-to-metal wafer bonding step (step S5), the inserted dies 108 and the target substrate 100 are brought into contact with the one or more target bonding pads 102 of the target wafer 100. In case of aluminium bonding pads, the bonding process may be carried out with a bonding pressure of up to 60 MPa, a temperature of up to 300 °C and a bonding time of up to 1 hour. Afterwards, the carrier wafer 104 and the target substrate 100 are cooled and the target substrate 100 with the bonded dies 116 can easily be separated from the carrier wafer 104. During the separation it is preferred to enable a highly-accurate parallel separation not to risk any mechanical contact between the pocket 106 and the transferred edges of the dies 108.

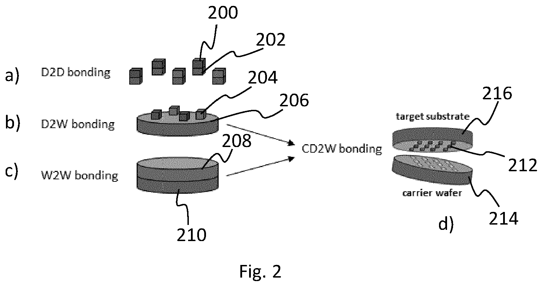

Figure 2 schematically and exemplary shows the concepts of a) die-to-die (D2D) bonding, of b) die-to-wafer (D2W) bonding and c) wafer-to-wafer (W2W) bonding. In d), the concept of collective die-to-wafer (CD2W) bonding is shown. In D2D bonding, a first die 200 is bonded to a second die 202. In D2W bonding, dies 204 are bonded to a wafer 206. In W2W bonding, a first wafer 208 is bonded to a second wafer 210. In CD2W bonding, the individual dies 212 are first placed on a carrier wafer 214 and then bonded to a target substrate 216 using known W2W bonding techniques.

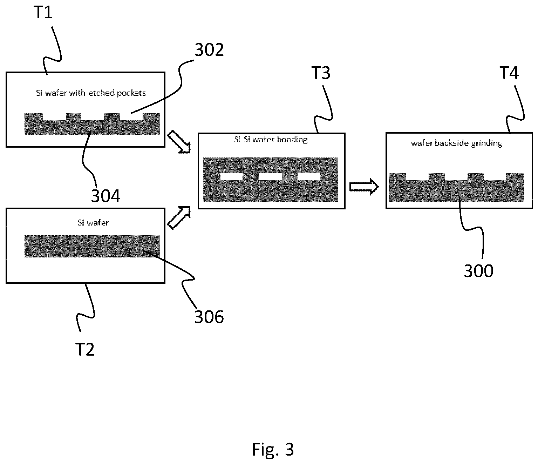

Figure 3 shows a flow diagram representing a method of fabricating a carrier wafer 300. In the boxes of the flow diagram, intermediate products of the method of fabricating a carrier wafer 300 are schematically and exemplary depicted.

In the method of fabricating a carrier wafer 300, pockets 302 with a size depending on the dies to be inserted are etched into a first wafer 304, e.g., a silicon substrate (step T1). A typical depth of the pockets has 200 µm to 400 µm. Furthermore, a blanked second wafer 306, e.g., a Si wafer is provided (step T2). Subsequently, the etched first wafer 304 is bonded face to face to the second wafer 306 (step T3). The bonding of the first wafer 394 and the second wafer 306 can be performed, e.g., by Si-Si direct bonding using a high vacuum bonding system but also by other bonding methods such as SiOz-SiOz bonding or metal-metal bonding.

When using Si-Si direct bonding, both, the first wafer 304 and the second wafer 306 are activated with an argon plasma to remove any surface oxides. To prevent re-oxidation the first wafer 304 and the second wafer 306 may be handled under high vacuum during the entire bonding process, which may be carried out at room temperature. Typical process conditions are a bonding time of up to 1 min and a bonding force of up to 60 kN.

Afterwards, the bonded first wafer 304 is ground until the etched pockets 302 are exposed. The grinding can be carried out employing a mechanical grinding process, chemical-mechanical polishing or wet/dry etching.

This approach of fabricating a carrier wafer 300 ensures that the pockets 302 have a substantially constant depth due to minimum total thickness variations of the carrier wafer 300. A substantially constant pocket depth is desired to ensure that the bonding interface of all individual chips will have the same height level to provide a high yield bonding process. The wafer carrier 300 may be made of silicon. However, other materials may be used such as glass. The carrier wafer 300 is reusable, i.e., the carrier wafer 300 can be used several times for bonding of different groups of dies.

In an alternative method of fabricating a carrier wafer, pockets are directly formed in the carrier wafer, e.g., via direct etching. In this case, it is not necessary to bond a first wafer having pockets to a blanked second wafer as described above.

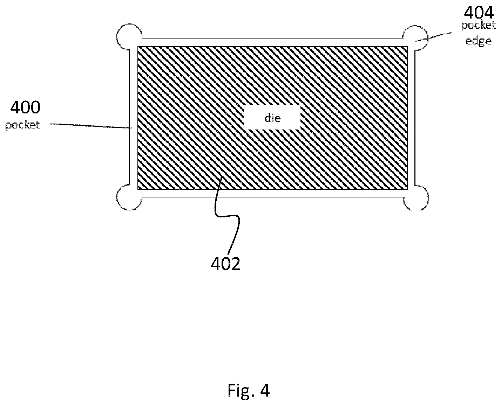

Figure 4 schematically and exemplary shows a pocket 400 with an inserted die 402 in a top view. The pocket 400 has a rectangular shape but may also have any other shape dependent on the process. If rectangular shapes are applied, an increased edge remove 404 is advantageous to avoid chipping of the IC's during die placement as the edges of dies 402 have the highest risk for cracking.

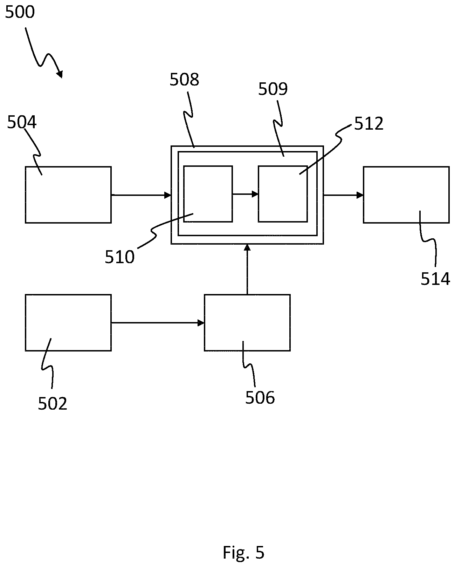

Figure 5 schematically and exemplary shows a system 500 for collective die-to-wafer bonding. The system 500 can be or can comprise a high vacuum handling cluster. With the system 500, the method of collective die-to-wafer bonding described with reference to figure 1 can be carried out.

The system 500 comprises a carrier wafer providing unit 502 that is configured for providing a wafer carrier with pockets, e.g., a wafer carrier as described with reference to figure 3. For example, the carrier wafer providing unit 502 may comprise a carrier wafer robot arm configured for handling the carrier wafer. Optionally, the carrier wafer providing unit 502 may comprise a pocket etching unit configured for etching of the one or more pockets, e.g. using lithographic techniques. Moreover, the carrier wafer providing unit 502 may be configured for bonding a first wafer having pockets to a blanked second wafer for providing the carrier wafer, e.g., as described with reference to figure 3.

Moreover, the system 500 comprises a target substrate providing unit 504 configured for providing a target substrate that has a target IC, and a plurality of target bonding pads for connecting dies arranged in the pockets of the carrier wafer to the target IC. The target substrate providing unit 504 may comprise a target substrate robot arm configured for handling the target substrate.

Furthermore, system 500 comprises a die placement unit 506 that is configured for placing one or more dies in the one or more pockets of the carrier wafer. The dies inserted into the pockets are brought into contact with the target substrate and handled to a die bonding unit 508, e.g., comprising a bonding chamber 509. In the die bonding unit 508, the one or more dies placed in the one or more pockets of the carrier wafer can be bonded to the target substrate using known wafer-to-wafer bonding techniques. That is, the bonding chamber 509 preferably is configured to provide one or more predetermined bonding conditions within the bonding chamber 509. One or more predetermined bonding conditions can be, e.g., for an aluminium-to-aluminium bonding, a bonding pressure of up to 60MPa, a temperature of up to 300 °C and a bonding time of up to 1 hour.

In particular, the metal-to-metal wafer bonding step is preferably carried out in a high vacuum handling cluster with several modules. For example, the die bonding unit 508 may comprise an activation module 510 configured for performing a dry etch process for activating the one or more target bonding pads and/or die bonding pads. For example, in the activation module 510, a dry etch process may be employed to remove the oxide and potential contaminations on the die bonding pads and target bonding pads.

Furthermore, the die bonding unit 508 comprises vacuum align module 512 that is configured for optically aligning the carrier wafer and the target substrate. In operation, without breaking vacuum to avoid a re-oxidation, the carrier wafer and the target substrate may be handled to the vacuum align module 512 were the flipped target substrate can be optically aligned to the carrier wafer. An optical alignment to the carrier wafer is preferred to compensate a potential misalignment of a limited number of individual dies. Optionally, the die bonding unit 508 may comprise a bonding robot arm that is configured for bringing the one or more dies in contact with the one or more target bonding pads. After bonding, the target substrate with bonded dies can be cooled to room temperature.

The system further comprises a debonding unit 514 to which the target substrate with bonded dies and the carrier wafer can be transferred for debonding of the dies and the carrier wafer. To this end, the debonding unit 514 may comprise a debonding tool that is configured for separating the dies from the carrier wafer. In particular, the debonding tool is configured to provide a parallel separation that reduces a risk of any mechanical contact between the pocket and the die edges of the dies.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

Any reference signs in the claims should not be construed as limiting the scope.

## Claims

1. A method of performing collective die-to-wafer bonding, the method comprising the steps of:
- providing a carrier wafer having a back side and a bonding side opposite the back side and comprising on the bonding side one or more pockets that each are configured for accommodating a die, respectively,
- providing a target substrate comprising an integrated circuit, hereinafter target IC, and one or more target bonding pads for connecting the one or more dies to the target IC,
- placing one or more dies in the one or more pockets, respectively, and
- bonding the one or more dies placed in the one or more pockets to the target substrate by bringing the one or more dies into contact with the one or more target bonding pads.

2. The method according to claim 1, wherein providing the carrier wafer comprises etching the one or more pockets into a first wafer and bonding the first wafer to a second wafer to obtain the carrier wafer, wherein the first wafer comprising the one or more pockets forms the bonding side of the carrier wafer.

3. The method of claim 2, wherein the bonded first wafer is ground until the one or more etched pockets are exposed to form the bonding side of the carrier wafer.

4. The method according to at least one of the preceding claims, wherein a thickness of the one or more dies is greater than a depth of the one or more pockets that accommodate the one or more dies, respectively.

5. The method according to at least one of the preceding claims, wherein a given pocket of the one or more pockets, seen in a top view, defines an opening that is no more than 1 µm larger in each lateral direction than a surface area of a cross-section of a die of the one or more dies that is to be placed in that pocket.

6. The method according to at least one of the preceding claims, wherein placing the one or more dies in the one or more pockets comprises aligning the one or more dies relative to the one or more pockets, wherein, preferably, the alignment of the one or more dies is performed with reference to an alignment feature, preferably, one or more side walls of the pocket, inherent to the one or more corresponding pockets, respectively, or with reference to one or more alignment marks present on the carrier wafer and having a known spatial relationship relative to the one or more pockets, respectively.

7. The method according to at least one of the preceding claims, wherein a pocket of the one or more pockets has at least one increased edge removal configured as a recess at a pocket's edge formed by two adjacent side walls of the pocket.

8. The method according to at least one of the preceding claims, wherein the one or more dies are placed in the one or more pockets such that one or more die bonding pads provided on each of the one or more dies, respectively, faces away from the wafer carrier.

9. The method according to at least one of the preceding claims, comprising - prior to the bonding - activating the target bonding pad and/or the die bonding pad using a dry etch process.

10. The method according to at least one of the preceding claims, comprising separating the one or more bonded dies from the carrier wafer by moving the carrier wafer away from the target substrate.

11. A carrier wafer comprising a first wafer with one or more exposed pockets that are each configured for accommodating a respective die, the first wafer forming a bonding side of the carrier wafer, and a second wafer bonded to the first wafer, the second wafer forming a backside of the carrier wafer.

12. A target substrate comprising an integrated circuit, hereinafter target IC, with target bonding pads and one or more dies each die comprising a die bonding pad, wherein the dies are connected to the target bonding pads via the die bonding pads, respectively.

13. A system for collective die-to-wafer bonding, the system comprising:
- a carrier wafer providing unit configured for providing a wafer carrier having a back side and an opposite bonding side and comprising on the bonding side one or more pockets that each are configured for accommodating a die,
- a target substrate providing unit configured for providing a target substrate comprising an integrated circuit, hereinafter target IC, and one or more target bonding pads for connecting the one or more dies to the target IC,
- a die placement unit configured for placing one or more dies in the one or more pockets, respectively, and
- a die bonding unit configured for bonding the one or more dies placed in the one or more pockets to the target substrate by bringing the one or more dies in contact with the one or more target bonding pads.

14. The system according to claim 13, wherein the die bonding unit comprises vacuum align module configured for optically aligning the carrier wafer and the target substrate.

15. The system according to claim 13 or 14, wherein the die bonding unit comprises bonding robot arm configured for bringing the one or more dies in contact with the one or more target bonding pads and/or for separating the bonded dies from the carrier wafer.
